# EUROPÄISCHE PATENTSCHRIFT

(11) **EP 2 316 128 B1**
(45) Veröffentlichungstag und Bekanntmachung des Hinweises auf die Patenterteilung: **10.10.2012**
(21) Anmeldenummer: 09779943.1
(22) Anmeldetag: 25.06.2009
(51) Int. Cl.: H01L 25/16, H01L 23/31, H01L 23/433, H01L 23/498

(54) **LEISTUNGSELEKTRONIKEINRICHTUNG**
POWER ELECTRONICS DEVICE
DISPOSITIF ÉLECTRONIQUE DE PUISSANCE

(30) Priorität: 16.07.2008 DE 102008040466
(43) Veröffentlichungstag der Anmeldung: 04.05.2011
(73) Patentinhaber: Robert Bosch GmbH, 70442 Stuttgart (DE)
(72) Erfinder: DUERR, Johannes, 72770 Reutlingen (DE); KEIL, Stefan, 72072 Tuebingen (DE); KIRCHER, Jochen, 72760 Reutlingen (DE); VOEGELE, Georg, 72768 Reutlingen (DE); DILLMANN, Adolf, 72525 Muensingen (DE)
(86) Internationale Anmeldenummer: PCT/EP2009/057954
(87) Internationale Veröffentlichungsnummer: WO 2010/006912

(56) Entgegenhaltungen:
- WO-A-2007/025134
- DE-A1- 10 260 851
- DE-A1- 19 758 569
- DE-A1-102005 025 083
- GB-A- 2 279 807
- GB-A- 2 292 010
- US-A1- 2003 000 739
- US-A1- 2006 109 630

## Beschreibung

Die Erfindung bezieht sich auf eine Leistungselektronikeinrichtung mit einem auf einer Grundplatte angeordneten Elektronikbauteil.

### Stand der Technik

In der DE 102 60 851 A1 wird eine Leistungselektronikeinrichtung mit einem Leistungsbauteil beschrieben, das auf einem Kühlkörper angeordnet ist, wobei das Leistungsbauelement über Bond-Drahtverbindungen mit einem Schaltungsträger elektrisch gekoppelt ist. Der Schaltungsträger und der Kühlkörper des Leistungsbauelementes sind auf einer gemeinsamen Grundplatte gehalten. Als Leistungsbauelemente kommen beispielsweise Leistungshalbleiter wie Leistungstransistoren, Leistungsdioden oder Asics in Betracht.

Grundsätzlich besteht bei derartigen Leistungselektronikeinrichtungen zum einen das Problem, dass auf Grund der hohen Wärmeentwicklung während des Betriebs eine effiziente Wärmeableitung gewährleistet sein muss. Zum andern muss das Bauteil eine hohe mechanische Stabilität aufweisen.

Die DE 10 2005 025 083 A1 offenbart eine in einem Thermoplast-Duvoplast Verhund eingekopelte Leistungselektronikeinrichtung.

### Offenbarung der Erfindung

Der Erfindung liegt die Aufgabe zu Grunde, mit einfachen Maßnahmen eine kompakt bauende Elektronikeinrichtung anzugeben, die sich durch eine gute Wärmeableitung und eine hohe mechanische Belastbarkeit auszeichnet.

Diese Aufgabe wird erfindungsgemäß mit den Merkmalen des Anspruches 1 gelöst. Die Unteransprüche geben zweckmäßige Weiterbildungen an.

Die erfindungsgemäße Leistungselektronikeinrichtung weist ein Elektronikbauteil auf einer Grundplatte auf, wobei das Elektronikbauteil zum einen eine Leistungselektronikeinheit und zum andern eine Signalelektronikeinheit umfasst. Das Elektronikbauteil mit der Leistungselektronikeinheit und der Signalelektronikeinheit ist zumindest teilweise mit einem Kunststoffteil umspritzt.

Das Kunststoffteil verleiht der Leistungselektronikeinrichtung eine erheblich bessere mechanische Stabilität, indem zum einen ein fester Verbund zwischen den verschiedenen Bauteilen der Leistungselektronikeinrichtung geschaffen und zum andern ein mechanischer Schutz gegen Einwirkungen von außen erzielt wird. Gegebenenfalls kann auf ein zusätzliches Gehäuse verzichtet werden, was eine erhebliche Einsparung an Material und Montageaufwand darstellt.

Die Kunststoffumspritzung weist darüber hinaus auch thermische Vorteile auf, indem die Wärme entwickelnden Elektronikbauteile von der Kunststoffumspritzung gegen einen Kühlkörper gedrückt oder mit Kühlkörpern verbunden werden, wodurch eine bessere thermische Anbindung der Elektronikbauteile in Bereichen besonders hoher Wärmeentwicklung an ein Wärme ableitendes Bauteil erreicht wird.

Außerdem hat die Kunststoffumspritzung den Vorteil, dass das Elektronikbauteil im Bereich der Umspritzung elektrisch isoliert ist.

Das Kunststoffteil, mit dem das Elektronikbauteil umspritzt ist, besteht vorzugsweise aus Duroplast. Dieses Material, das sich im ausgehärteten Zustand durch eine große Härte auszeichnet, kann im Mold-Verfahren, insbesondere bei einem Transfer-Mold-Prozess auf das Elektronikbauteil aufgebracht werden.

Grundsätzlich kommen auch Kunststoffteile aus anderen Werkstoffen in Betracht. So kann es zweckmäßig sein, ein Kunststoffteil aus thermoplastischem Werkstoff zu verwenden, das vorzugsweise aufgespritzt wird, insbesondere im Injektions-Mold-Verfahren. Gemäß einer bevorzugten Ausführung ist vorgesehen, dass das Elektronikbauteil in einem ersten Schritt mit dem Duroplast umspritzt wird und anschließend in einem zweiten Schritt der thermoplastische Werkstoff aufgetragen wird, wobei das Thermoplast-Kunststoffteil zweckmäßigerweise zumindest zum Teil auch das Duroplast-Kunststoffteil umschließt. Das Thermoplast-Kunststoffteil liegt im fertig montierten Zustand zweckmäßigerweise unmittelbar an einem Grundkörper an, der insbesondere als Kühlkörper zur Wärmeableitung ausgeführt ist.

Die Kunststoffumspritzung erstreckt sich vorteilhafterweise sowohl auf die Leistungselektronikeinheit als auch auf die Signalelektronikeinheit. Es kann jedoch zweckmäßig sein, lediglich den Bereich der Leistungselektronikeinheit mit dem Duroplast-Werkstoff zumindest teilweise zu umspritzen, nicht jedoch die Signalelektronikeinheit. Dagegen kann der thermoplastischen Kunststoff auch die Signalelektronikeinheit zumindest bereichsweise überdecken. Es sind aber grundsätzlich auch andere Umspritzungsverhältnisse möglich, beispielsweise das Aufbringen des Duroplast-Werkstoff sowohl auf Abschnitte der Leistungselektronikeinheit als auch der Signalelektronikeinheit oder das Aufbringen des thermoplastischen Kunststoff ausschließlich auf einen Abschnitt der Leistungselektronikeinheit oder ausschließlich auf einen Abschnitt der Signalelektronikeinheit. Denkbar ist es auch, den Duroplast-Werkstoff ausschließlich auf einen Abschnitt der Signalelektronikeinheit aufzubringen.

Da die erheblich größere Wärmeentwicklung im Bereich der Leistungselektronikeinheit stattfindet, können an dieser Stelle zusätzliche, Wärme ableitende Maßnahmen getroffen sein. In Betracht kommt das Anbringen einer so genannten Wärmeleitpaste zwischen einem außen liegenden Element des Elektronikbauteils und einem umgebenden Körper, insbesondere der Grundplatte bzw. dem Kühlkörper, wobei die Wärmeleitpaste auf Grund ihrer Konsistenz bei der Herstellung der Leistungselektronikeinheit leichter aufgetragen werden kann und auf Grund ihrer guten Wärmeleitfähigkeit für eine entsprechend gute Wärmeableitung in Richtung des benachbarten, die Wärme aufnehmenden Körpers sorgt.

Des Weiteren sind der Leistungselektronikeinheit Kupferschichten zugeordnet, die zum einen für einen elektrischen Kontakt zu den Halbleiterelementen der Leistungselektronikeinheit sorgen, zum andern aber auch auf Grund ihrer hohen Wärmekapazität als Wärmespeicher dienen, der nach Art eines Puffers kurzfristige Wärmespitzen aus der Leistungselektronikeinheit aufnimmt und nach außen abgibt.

Die elektrischen Verbindungen zwischen den diversen Bauelementen innerhalb des Elektronikbauteils, insbesondere zwischen der Leistungselektronikeinheit und der Signalelektronikeinheit sowie zwischen den Halbleiterelementen der Leistungselektronikeinheit und einem Stanzgitter, vorzugsweise der Kupferschicht, kann auf verschiedene Weise durchgeführt werden. In Betracht kommen Löt-, Sinter-, Bond-Verbindungen oder Federkontakte. Hierbei können verschiedene oder auch gleichartige Verbindungsarten zwischen den verschiedenen Elementen der Leistungselektronikeinheit miteinander kombiniert werden.

### Mit der erfindungsgemäß aufgebauten

Leistungselektronikeinrichtung erhält man eine integrierte Power Unit (IPU) mit Leistungselektronik, Signalelektronik, Außenkontaktierungen zu Sensoren, Aktuatoren und/oder Steckern sowie Elemente zur Realisierung interner Stromverbindungen, die sich durch eine kompakte Bauweise bei hoher mechanischer Festigkeit und Widerstandsfähigkeit und zugleich guter Wärmeableitung auszeichnet.

Weitere Vorteile und zweckmäßige Ausführungen sind den weiteren Ansprüchen, der Figurenbeschreibung und den Zeichnungen zu entnehmen. Es zeigen:
- Fig. 1: eine Leistungselektronikeinrichtung im Schnitt, umfassend ein Elektronikbauteil mit einer Leistungselektronikeinheit und einer Signalelektronikeinheit, wobei das Elektronikbauteil teilweise von einem Kunststoff umspritzt und auf einem Kühlkörper angeordnet ist, mit Bond- und Federkontaktverbindungen zwischen verschiedenen Bauelementen des Elektronikbauteils,
- Fig. 2: in vergrößerter Darstellung einen Schnitt durch den Bereich der Kontaktierung zwischen zwei Elementen der Leistungselektronikeinheit,
- Fig. 3: eine Fig. 1 entsprechende Darstellung einer Leistungselektronikeinrichtung, bei der der elektrische Kontakt zwischen der Leistungselektronikeinheit und der Signalelektronikeinheit als Bond-Verbindung ausgeführt ist,
- Fig. 4: noch eine weitere Leistungselektronikeinrichtung, bei der ein Halbleiterbauelement der Leistungselektronikeinheit zwischen zwei Kupferschichten eingebettet und mit diesen über eine Sinter- oder Lotschicht verbunden ist,
- Fig. 5: eine vergrößerte Darstellung aus dem Bereich der Leistungselektronikeinheit in einer weiteren Ausführungsvariante,
- Fig. 6: eine weitere Leistungselektronikeinrichtung, bei der die elektrische Verbindung zwischen der Leistungselektronikeinheit und der Signalelektronikeinheit über Federkontakte erfolgt,
- Fig. 7: einen Schnitt durch eine Leistungselektronikeinrichtung im Bereich der Verbindung zwischen einem Thermoplast-Kunststoffteil und einem unten liegenden Kühlkörper,
- Fig. 8: ein Ausschnitt aus einer Leistungselektronikeinrichtung mit FederkontaktVerbindungen,
- Fig. 9: ein weiterer Ausschnitt aus einer Leistungselektronikeinrichtung, dargestellt mit einer Verbindung der Signalelektronikeinheit zu einem nach außen führenden Stecker,
- Fig. 10: eine perspektivische Ansicht einer Leistungselektronikeinrichtung im Schnitt mit aufgesteckten Schneid-Klemm-Elementen zur elektrischen Verbindung mit der Leistungselektronikeinheit.

In den Figuren sind gleiche Bauteile mit gleichen Bezugszeichen versehen.

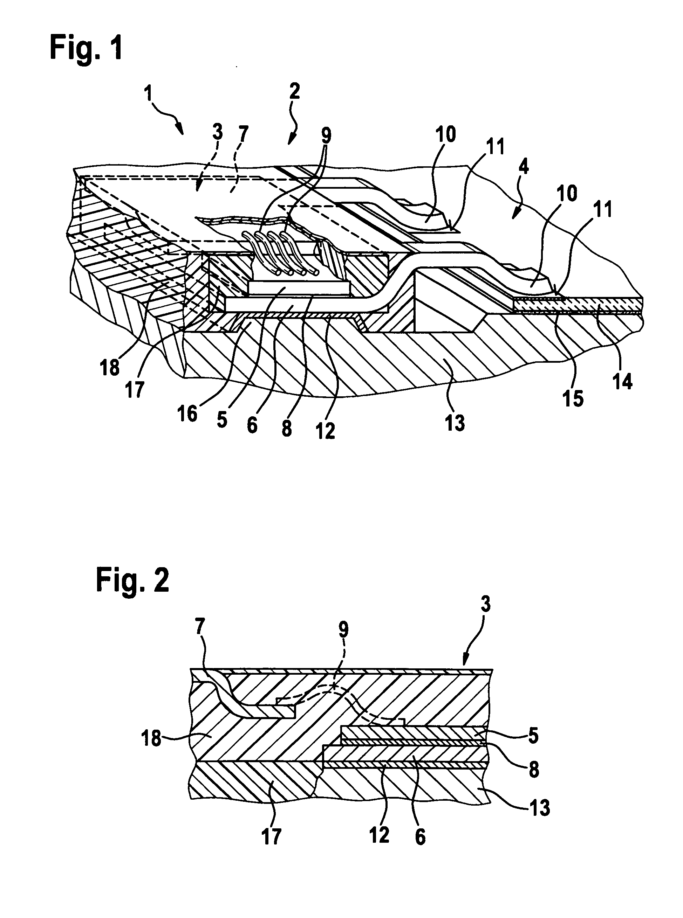

Bei der in Fig. 1 dargestellten Leistungselektronikeinrichtung 1 handelt es sich um eine integrierte Power Unit (IPU) mit einem Elektronikbauteil 2, das eine Leistungselektronikeinheit 3 und eine Signalelektronikeinheit 4 umfasst. Die Leistungselektronikeinheit 3 weist ein Leistungshalbleiterelement 5 auf, beispielsweise einen Chip, der elektrisch mit einer unteren Kupferschicht 6 und einer oberen Kupferschicht 7 verbunden ist. Die Verbindung zwischen dem Halbleiterelement 5 und der unteren Kupferschicht 6 erfolgt über eine elektrisch leitende Verbindungsschicht 8, die beispielsweise als Lotschicht oder als elektrisch leitfähige Sinterschicht ausgeführt ist. Die Topkontaktierung, also die elektrische Verbindung zwischen dem Halbleiterelement 5 und der darüber liegenden Kupferschicht 6 erfolgt über mehrere Bond-Drahtverbindungen 9.

### Die elektrische Verbindung zwischen der

Leistungselektronikeinheit 3 und der Signalelektronikeinheit 4 erfolgt mittels Federkontakten 10, über die die untere bzw. obere Kupferschicht 6, 7 über Kontaktierflächen 11 mit einem Bauteil der Signalelektronikeinheit 4 verbunden sind. Die Federkontakte 10 sind als geschwungene Federbügel ausgeführt, die einteilig mit der jeweiligen Kupferschicht 6 bzw. 7 ausgebildet sein können. Gegebenenfalls kommt aber auch eine separate Ausführung der Federkontakte als eigenständiges Bauteil in Betracht.

Das Elektronikbauteil 2 mit der Leistungselektronikeinheit 3 und der Signalelektronikeinheit 4 ist auf einer Grundplatte 13 aufgenommen, die bevorzugt als Kühlkörper ausgebildet ist und zur Wärmeableitung dient. Im Bereich der Leistungselektronikeinheit 3 befindet sich zwischen der Unterseite der unteren Kupferschicht 6 und einem erhöhten Sockel 16 der Grundplatte 13 eine Wärmeleitpaste 12, die gute Wärmeleiteigenschaften aufweist und die Wärmeableitung aus der unten liegenden Kupferschicht in den Kühlkörper 13 unterstützt. Auf Grund des erhöhten Sockels 16 des Kühlkörpers 13 findet eine thermisch enge Anbindung an dieser Stelle statt.

Im Bereich der Signalelektronikeinheit 4 ist ein Keramiksubstrat 14, welches Basisträger der Halbleiterelemente der Signalelektronikeinheit ist, über eine Klebstoffschicht 15 mit dem darunter liegenden Kühlkörper 13 verbunden. Auf Grund der geringeren Wärmeentwicklung der Signalelektronikeinheit 4 kann die Klebstoffschicht 15 ohne besondere Wärmeleiteigenschaften ausgestattet sein; ggf. kann aber auch an dieser Stelle eine Wärmeleitpaste mit hoher Wärmeleitfähigkeit eingesetzt werden. Das Elektronikbauteil 2 ist mit einem Kunststoff umspritzt. Hierzu ist insbesondere die Leistungselektronikeinheit 3 mit einem Duroplast-Kunststoff umspritzt, der ein die Leistungselektronikeinheit 3 zumindest teilweise umschließendes Duroplast-Kunststoffteil 17 bildet. Das Duroplast-Kunststoffteil 17 kann als Mold-Teil in einem Transfer-Mold-Prozess aufgebracht werden.

Des Weiteren ist ein Thermoplast-Kunststoffteil 18 vorgesehen, welches ebenfalls die Leistungselektronikeinheit 3 zumindest teilweise einschließt und in einem zweiten, darauffolgenden Spritzprozess aufgebracht ist; das Thermoplast-Kunststoffteil 18 schließt somit auch das im ersten Spritzprozess aufgebracht Duroplast-Kunststoffteil 17 zumindest teilweise ein.

Auch die Signalelektronikeinheit 4 kann zumindest teilweise von dem Duroplast-Kunststoffteil 17 umschlossen sein, beispielsweise auf der dem Kühlkörper 13 abgewandten Oberseite. Gegebenenfalls umschließt auch das Thermoplast-Kunststoffteil 18 die Signalelektronikeinheit 4 zumindest teilweise.

Die Kunststoffteile 17 und 18 bewirken zum einen einen mechanischen Schutz des Elektronikbauteils 2, insbesondere der Leistungselektronikeinheit 3. Zum andern wird eine feste Anbindung des Elektronikbauteils 2 an die Grundplatte 13 erreicht. Durch die feste Anbindung wird ein flächiger Kontakt zwischen dem Sockel 16 an der Grundplatte 13 und dem darüber liegenden Bauteil 13 der Leistungselektronikeinheit 13 erzielt, wodurch eine thermische Anbindung an die Grundplatte 13 unterstützt und die Wärmeableitung verbessert wird.

Eine weitere thermische Verbesserung ist durch den Einsatz der Kupferschichten 6 und 7 gegeben, die als Einlegeteil mit hoher Wärmekapazität als Wärmepuffer dienen und die vom Halbleiterelement 5 erzeugte Wärme aufnehmen und nach außen bzw. an den Kühlkörper abgeben.

Fig. 2 ist der elektrische Kontakt zwischen dem Halbleiterelement 5 in der Leistungselektronikeinheit zur oberen Kupferschicht 7 einerseits und zwischen dem Halbleiterelement 5 und der unteren Kupferschicht 6 andererseits in vergrößerter Darstellung zu entnehmen. Die untere Kupferschicht 6 liegt unmittelbar unterhalb des Halbleiterelementes 5 und ist mit diesem elektrisch über die Verbindungsschicht 8, beispielsweise eine Lotschicht oder eine elektrisch leitende Sinterschicht verbunden. Die obere Kupferschicht 7 ist gegenüber dem Halbleiterelement 5 seitlich versetzt angeordnet, wobei der Versatz über die Bond-Drahtverbindung 9 überbrückt wird.

Die Bond-Drahtverbindung 9 ist vollständig von dem Duroplast-Kunststoffteil 17 umspritzt, ebenso die Oberseite des Halbleiterelementes 5. Die obere Kupferschicht 6 ist teilweise, zumindest aber im Bereich des Kontaktes zur Bond-Drahtverbindung 9 mit dem Duroplast-Kunststoffteil 17 umspritzt.

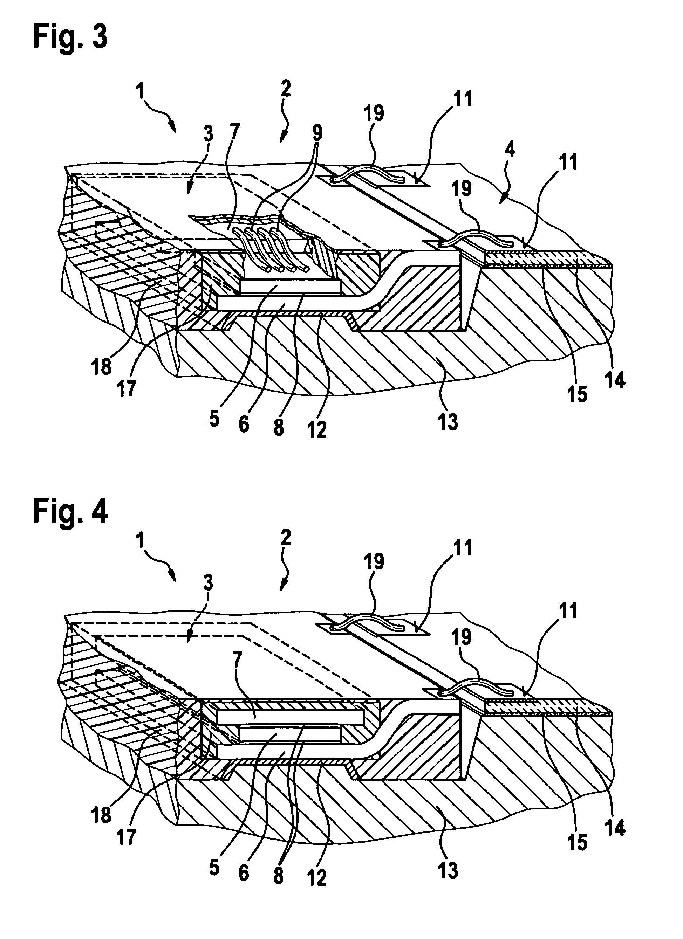

Die in Fig. 3 dargestellte Leistungselektronikeinrichtung 1 entspricht weitgehend derjenigen aus dem Ausführungsbeispiel nach Fig. 1, so dass insoweit auf die obenstehende Beschreibung verwiesen wird. Im Unterschied zum Ausführungsbeispiel nach Fig. 1 ist jedoch bei der Leistungselektronikeinrichtung nach Fig. 3 die elektrische Verbindung zwischen der Leistungselektronikeinheit 3 und der Signalelektronikeinheit 4 als Bond-Drahtverbindung 19 ausgeführt, über die die Kupferschichten 6 und 7 der Leistungselektronikeinheit 3 elektrisch über die Kontaktierflächen 11 mit den Halbleiterbauelementen der Signalelektronikeinheit 4 verbunden sind. Derartige Bond-Drahtverbindungen 9 finden sich auch zwischen dem Halbleiterelement 5 der Leistungselektronikeinheit 3 und der darüber liegenden, oberen Kupferschicht 7.

Das Ausführungsbeispiel gemäß Fig. 4 entspricht weitgehend demjenigen nach Fig. 3, jedoch mit dem Unterschied, dass der elektrische Kontakt zwischen dem Leistungshalbleiterelement 5 in der Leistungselektronikeinheit 3 sowohl zur unteren Kupferschicht 6 als auch zur darüber liegenden Kupferschicht 7 über eine elektrisch leitfähige Verbindungsschicht 8 hergestellt wird, beispielsweise eine Lotschicht oder eine elektrisch leitfähige Sinterschicht. Um dies zu realisieren, muss die obere Kupferschicht 7 zumindest teilweise in Überdeckung zur Oberseite des Halbleiterelementes 5 liegen.

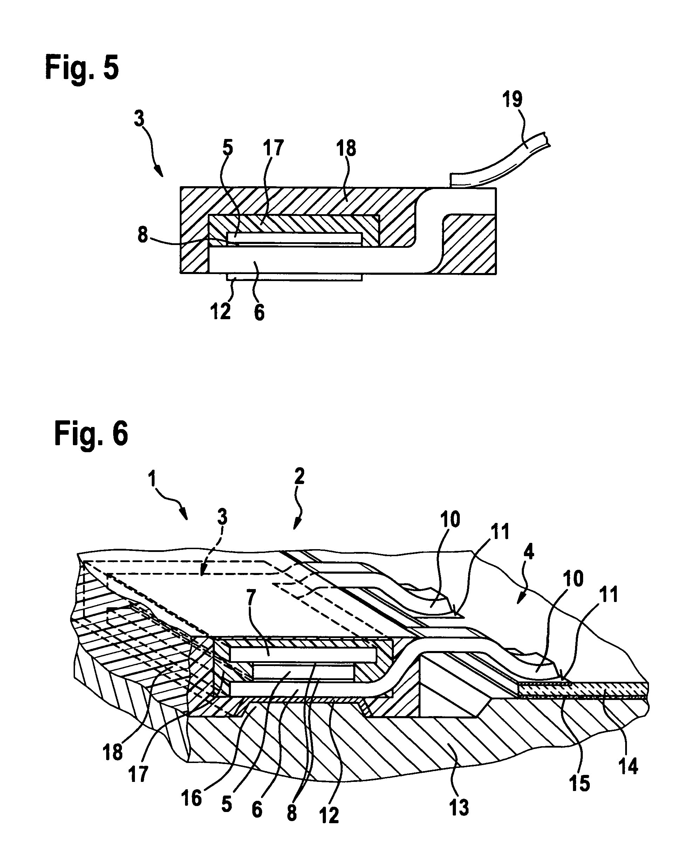

Wie Fig. 5 zu entnehmen, ist das Halbleiterelement 5 in der Leistungselektronikeinheit 3 auf der Oberseite von dem Duroplast-Kunststoffteil 17 umspritzt. Das Duroplast-Kunststoffteil 17 ist von dem Thermoplast-Kunststoffteil 18 umspritzt, das auch die Seitenflächen des Duroplast-Kunststoffteils 17, des Halbleiterelements 5 sowie der unteren Kupferschicht 6 überdeckt. Die Kupferschicht 6 ist im Übergang zur angrenzenden Signalelektronikeinheit 4 gebogen ausgebildet, wobei der gebogene Abschnitt vollständig in das Thermoplast-Kunststoffteil 18 eingebettet ist.

Im Ausführungsbeispiel gemäß Fig. 6 erfolgt der elektrische Kontakt zwischen der Leistungselektronikeinheit 4 über Federkontakte 10, die als bügelartige Endabschnitte der jeweiligen Kupferschicht 6 und 7 ausgebildet sind und über Kontaktierflächen 11 elektrisch mit der Signalelektronikeinheit 4 verbunden sind. Der elektrische Kontakt zwischen dem Halbleiterelement 5 in der Leistungselektronikeinheit 3 und der darunter bzw. darüber liegenden Kupferschicht 6 bzw. 7 erfolgt über eine elektrische Verbindungsschicht 8, die wie in den vorangegangenen Ausführungsbeispielen entweder als Lotschicht oder als elektrisch leitfähige Sinterschicht ausgeführt sind.

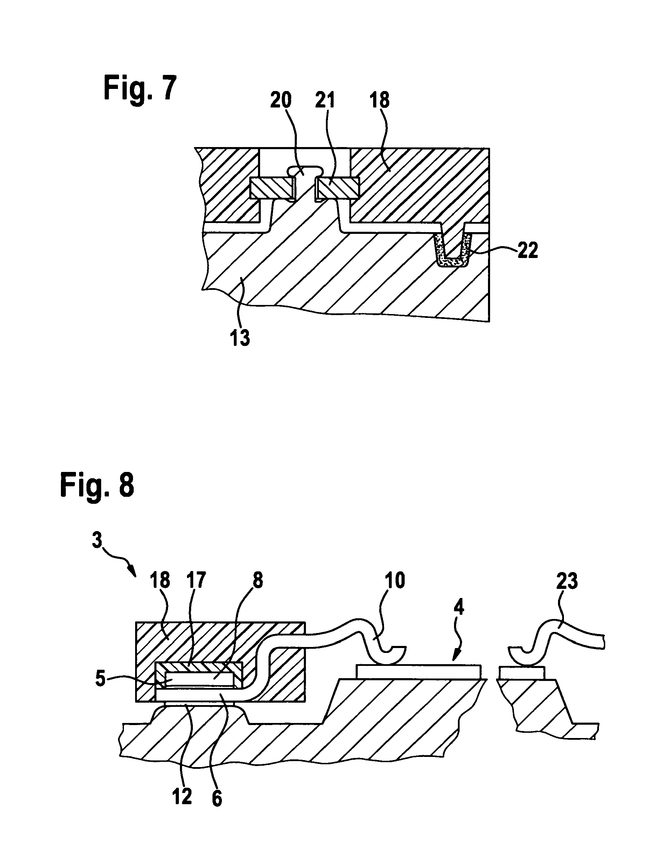

In Fig. 7 ist die Befestigung und Abdichtung des Thermoplast-Kunststoffteils 18 am Kühlkörper 13 dargestellt. Zum einen erfolgt die Befestigung über einen Nietring 21, der auf einem überstehenden, einstückig mit dem Kühlkörper 13 ausgebildeten Niet 20 aufgesetzt ist und dessen radial Außenseiten in das Thermoplast-Kunststoffteil 18 eingebettet sind. Zum andern ist am Thermoplast-Kunststoffteil 18 ein Absatz angeformt, der in eine korrespondierende Nut im Kühlkörper 13 einragt und über eine Klebeschicht 22 mit dem Kühlkörper verklebt ist.

Fig. 8 zeigt nochmals die elektrische Verbindung zwischen der Leistungselektronikeinheit 3 und der Signalelektronikeinheit 4 über einen Federkontakt 10, der als gebogener Endabschnitt der unteren Kupferschicht 6 ausgebildet ist. Die Signalelektronikeinheit 4 kann über einen weiteren Federkontakt 23 mit einer weiteren Baueinheit verbunden sein, beispielsweise mit einem Stecker.

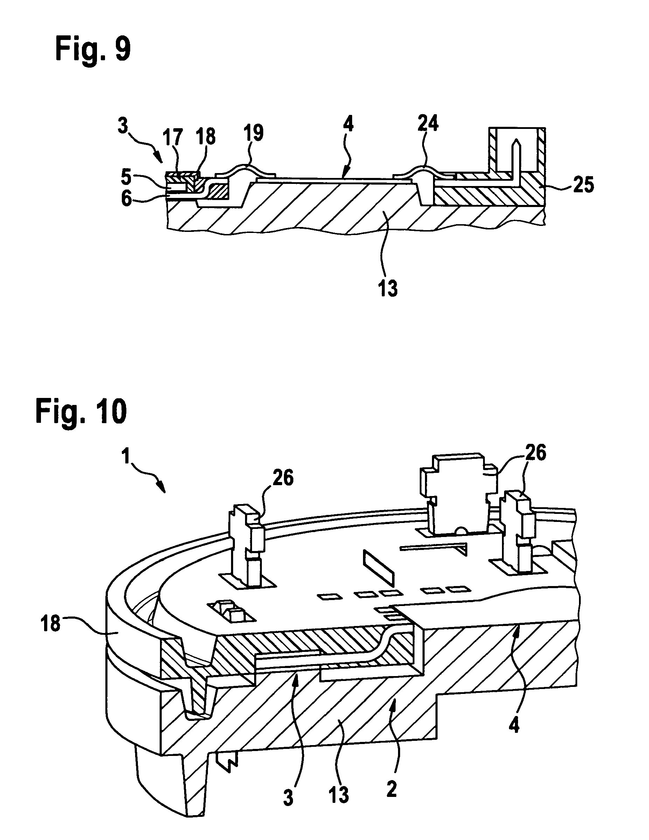

In Fig. 9 ist die Verbindung zwischen der Leistungselektronikeinheit 3 und der Signalelektronikeinheit 4 als Bond-Drahtverbindung ausgeführt. Ebenfalls als Bond-Drahtverbindung 24 erfolgt der elektrische Kontakt zwischen der Signalelektronikeinheit 4 und einem Steckerteil 25, über den ein Kontakt zu einem weiteren, nicht dargestellten Bauteil hergestellt werden kann.

Wie der Darstellung nach Fig. 10 zu entnehmen, können in die Oberseite der Leistungselektronikeinrichtung 1 Schneid-Klemm-Elemente 26 durch das die Oberseite überdeckende Thermoplast-Kunststoffteil 18 geführt sein. Die Schneid-Klemm-Elemente 26 kontaktieren die Leistungselektronikeinheit 3, insbesondere die Leistungshalbleiterelemente.

## Patentansprüche

1. Leistungselektronikeinrichtung, mit einem auf einer Grundplatte (13) angeordneten Elektronikbauteil (2), wobei das Elektronikbauteil (2) eine Leistungselektronikeinheit (3) und eine Signalelektronikeinheit (4)umfasst, wobei die Leistungselektronikeinheit (3) ein Leistungshalbleiterelement (5) aufweist, das elektrisch mit einer unteren Kupferschicht (6) und einer oberen Kupferschicht (7) verbunden ist, und wobei die Leistungselektronikeinheit (3) und die Kupferschichten (6, 7) zumindest teilweise mit einem Kunststoffteil aus Duroplast (17) und einem Kunststoffteil aus einem thermoplastischen Werkstoff(18) umspritzt sind.

2. Leistungselektronikeinrichtung nach Anspruch 1,
**dadurch gekennzeichnet, dass** das Duroplast-Kunststoffteil (17) unmittelbar auf das Elektronikbauteil (2) aufgebracht und das Thermoplast-Kunststoffteil (18) auf das Duroplast-Kunststoffteil (17) aufgebracht ist.

3. Leistungselektronikeinrichtung nach einem der Ansprüche 1 oder 2,
**dadurch gekennzeichnet, dass** das Kunststoffteil (17, 18) das Elektronikbauteil (2) mit der Grundplatte (13) verbindet.

4. Leistungselektronikeinrichtung nach einem der Ansprüche 1 bis 3 ,
**dadurch gekennzeichnet, dass** zwischen einer Kupferschicht (6) und der Grundplatte (13) eine Schicht aus Wärmeleitpaste (12) liegt.

5. Leistungselektronikeinrichtung nach einem der Ansprüche 1 bis 4,
**dadurch gekennzeichnet, dass** die Grundplatte (13) als Kühlkörper ausgeführt ist und benachbart zur Kupferschicht (6) einen erhöhten Sockel (16) aufweist, der im Bereich der Leistungselektronikeinheit (3) angeordnet ist, wobei zwischen der Unterseite der Kupferschicht (6) und dem erhöhten Sockel (16) eine Wärmeleitpaste (12) angeordnet ist.

6. Leistungselektronikeinrichtung nach Anspruch 5,
**dadurch gekennzeichnet, dass** die elektrische Verbindung zwischen dem Leistungshalbleiter (5) und den Kupferschichten (6, 7) durch Löten, Sintern, Bonden oder über Federkontakt (23) erfolgt.

7. Leistungselektronikeinrichtung nach einem der Ansprüche 1 bis 6,
**dadurch gekennzeichnet, dass** die elektrische Verbindung zwischen der Leistungselektronikeinheit (3) und der Signalelektronikeinheit (4) durch Löten, Bonden oder über Federkontakt (23) erfolgt.

8. Leistungselektronikeinrichtung nach einem der Ansprüche 1 bis 7,
**dadurch gekennzeichnet, dass** durch das Kunststoffteil ein Schneid-Klemm-Element (26) zur elektrischen Verbindung mit dem Elektronikbauteil (2), insbesondere mit der Leistungselektronikeinheit (3) geführt ist.

9. Leistungselektronikeinrichtung nach einem der Ansprüche 1 bis 4,
**dadurch gekennzeichnet, dass** die Grundplatte (13) als Kühlkörper ausgeführt ist.

## Claims

1. Power electronics device, comprising an electronics component (2) arranged on a baseplate (13), wherein the electronics component (2) comprises a power electronics unit (3) and a signal electronics unit (4), wherein the power electronics unit (3) has a power semiconductor element (5), which is electrically connected to a lower copper layer (6) and an upper copper layer (7) and wherein the power electronics unit (3) and the copper layers (6, 7) are at least partly encapsulated by moulding with a plastics part composed of thermosetting plastic (17) and a plastics part composed of a thermoplastic material (18).

2. Power electronics device according to Claim 1, **characterized in that** the plastics part (17) composed of thermosetting plastic is applied directly to the electronics component (2) and the plastics part (18) composed of thermoplastic is applied to the plastics part (17) composed of thermosetting plastic.

3. Power electronics device according to either of Claims 1 and 2,
**characterized in that** the plastics part (17, 18) connects the electronics component (2) to the baseplate (13).

4. Power electronics device according to any of Claims 1 to 3,
**characterized in that** a layer of thermally conductive paste (12) lies between a copper layer (6) and the baseplate (13).

5. Power electronics device according to any of Claims 1 to 4,
**characterized in that** the baseplate (13) is embodied as a heat sink and has, adjacent to the copper layer (6) an elevated pedestal (16) arranged in the region of the power electronics unit (3), wherein a thermally conductive paste (12) is arranged between the underside of the copper layer (6) and the elevated pedestal (16).

6. Power electronics device according to Claim 5,
**characterized in that** the electrical connection between the power semiconductor (5) and the copper layers (6, 7) is effected by soldering, sintering, bonding or via spring contact (23).

7. Power electronics device according to any of Claims 1 to 6,
**characterized in that** the electrical connection between the power electronics unit (3) and the signal electronics unit (4) is effected by soldering, bonding or via spring contact (23).

8. Power electronics device according to any of Claims 1 to 7,
**characterized in that** an insulation displacement element (26) for electrical connection to the electronics component (2), in particular to the power electronics unit (3), is led through the plastics part.

9. Power electronics device according to any of Claims 1 to 4,
**characterized in that** the baseplate (13) is embodied as a heat sink.

## Revendications

1. Dispositif électronique de puissance doté d'un composant électronique (2) disposé sur une plaque de base (13),
le composant électronique (2) comprenant une unité (3) d'électronique de puissance et une unité (4) d'électronique de signalisation,
l'unité (3) d'électronique de puissance présentant un élément semi-conducteur de puissance (5) relié électriquement à une couche inférieure de cuivre (6) et à une couche supérieure de cuivre (7),
l'unité (3) d'électronique de puissance et les couches de cuivre (6, 7) étant englobées au moins en partie dans une pièce (17) en matière synthétique thermodurcissable et dans une pièce (18) en matière synthétique thermoplastique.

2. Dispositif électronique de puissance selon la revendication 1, **caractérisé en ce que** la pièce en matière synthétique thermodurcissable (17) est appliquée directement sur le composant électronique (2) et **en ce que** la pièce (18) en matière synthétique thermoplastique est appliquée sur la pièce (17) en matière synthétique thermodurcissable.

3. Dispositif électronique de puissance selon l'une des revendications 1 ou 2, **caractérisé en ce que** les pièces (17, 18) en matière synthétique relient le composant électronique (2) à la plaque de base (13).

4. Dispositif électronique de puissance selon l'une des revendications 1 à 3, **caractérisé en ce qu'**une couche de pâte (12) conductrice de la chaleur est placée entre une couche de cuivre (6) et la plaque de base (13).

5. Dispositif électronique de puissance selon l'une des revendications 1 à 4, **caractérisé en ce qu'**au voisinage de la couche de cuivre (6), la plaque de base (13) est configurée comme corps de refroidissement et présente un socle (16) surélevé disposé au niveau de l'unité (3) d'électronique de puissance, une pâte (12) conductrice de la chaleur étant placée entre le côté inférieur de la couche de cuivre (6) et le socle (16) surélevé.

6. Dispositif électronique de puissance selon la revendication 5, **caractérisé en ce que** la liaison électrique entre le semi-conducteur de puissance (5) et les couches de cuivre (6, 7) s'effectue par brasage, frittage, liaison ou par contact élastique (23).

7. Dispositif électronique de puissance selon l'une des revendications 1 à 6, **caractérisé en ce que** la liaison électrique entre l'unité (3) d'électronique de puissance et l'unité (4) d'électronique de signalisation s'effectue par brasage, liaison ou par contact élastique (23).

8. Dispositif électronique de puissance selon l'une des revendications 1 à 7, **caractérisé en ce qu'**un élément (26) de serrage et de coupe qui assure la liaison électrique avec le composant électronique (2) et en particulier avec l'unité (3) d'électronique de puissance est passé à travers la pièce en matière synthétique.

9. Dispositif électronique de puissance selon l'une des revendications 1 à 4, **caractérisé en ce que** la plaque de base (13) est configurée comme corps de refroidissement.
